# EUROPEAN PATENT APPLICATION

(11) **EP 3 933 516 A1**
(43) Date of publication of application: **05.01.2022**
(21) Application number: 20183100.5
(22) Date of filing: 30.06.2020
(51) Int. Cl.: G05B 17/02, G05B 19/418, G06Q 50/04

(54) **METHOD AND SYSTEM FOR CREATING OR UPDATING A DIGITAL TWIN**

(71) Applicant: Siemens Aktiengesellschaft, 80333 München (DE)
(72) Inventor: Brikis, Georgia Olympia, 81739 München (DE); Lamparter, Steffen, 85622 Feldkirchen (DE)

(57) **Abstract**

In order to create or update a digital twin (DT) modeling a physical system, data from several conjoint data sources (DS) are repeatedly extracted and semantically annotated, wherein semantic annotations of data that have been extracted from a first conjoint data source are influenced by previously extracted and semantically annotated data from at least one other conjoint data source. The semantically annotated data (GBS) can be used to create or update the digital twin. This provides a modular and easily expandable solution for enriching a digital twin from a plurality of conjoint data sources with heterogenous data. Various embodiments can provide an automated export (EPM) into different existing digital twin systems, for example PlantSight, COMOS or Teamcenter. The original data sources do not need to be changed. The solution is expandable to include all kinds of data sources with custom types. Import of data from various data sources with various data types as well as from existing digital twins can be triggered individually. The extracting and semantically annotating of the data are augmented with knowledge gained from previous annotations. Depending on the type of data imported, already known information can for example be used to dynamically create label spaces and embeddings. This way the processing of new data happens with awareness of already in other data sources identified entities, object and relations. Thus, processing of different data sources does not happen isolated from one another while the system remains modularly expandable to new data sources. Compared to previous approaches, instead of creating yet another stand-alone digital representation of the physical system that is not compatible with already existing solutions, these solutions are augmented with a modular data management pipeline.

## Description

A digital twin is a digital representation of a physical system. It is used to document, understand and predict the performance characteristics of its physical counterpart. Digital twins can be used in all lifecycle stages, capturing object characteristics from design, engineering, production, operation, service, maintenance, to end of life. They can be found throughout industry, from production digital twins, to performance and product digital twins.

Creating a digital twin for a given physical system is commonly associated with a long process that heavily relies on in-depth knowledge of the physical system in question. Essentially every characteristic and all available information about the physical system need to be copied to and recreated in a digital environment. Especially in case of complex physical systems, e.g. production systems, the creation of a digital twin is a time and resource straining undertaking.

The creation process is driven by the data that is available about the considered physical system. In (almost) all real-world applications this data is heterogenous, conjoint and comes from historically grown silos that lack clearly defined semantics.

For example, in production systems available data sources include engineering data (e.g. 3D models, equipment lists, tag lists) as well as runtime data, accounting information, custom specifications and industry standards.

For facilities or buildings, available data can address up to seven dimensions, including technical drawings, 3D models augmented over time, cost documentation, environmental and sustainability analyses and life-cycle facility management information.

Conjoint data are two or more data instances that relate to one and the same physical or abstract entity. Conjoint data are especially common when importing data from different sources. For example, when importing data from a 3D model of a physical asset and corresponding data about this asset from SAP, one might find accounting related information about the asset in the SAP data and structural information about that same asset in the 3D model.

The import of data into digital twin platforms for the purpose of creating a digital twin is to date done mostly by human-driven data entry. There are tools that support this process by addressing the import of specific data source formats. However, despite such tools existing the import and consolidation work remains largely left to the manual efforts of a human.

It is an object of the invention to provide an alternative to the state of the art.

According to the method for creating or updating a digital twin, a number of conjoint data sources are providing data about a physical system, wherein several or all of the conjoint data sources contain data instances that relate to a first entity of the physical system. The method comprises the steps of repeatedly extracting and semantically annotating data, by at least one processor, from at least one of the conjoint data sources, wherein semantic annotations of data that have been extracted from a first conjoint data source are influenced by previously extracted and semantically annotated data from at least one other conjoint data source, and exporting the semantically annotated data, by the processor or another processor, into a digital twin system in order to create or update a digital twin based on the semantically annotated data, with the digital twin being a digital representation of the physical system.

The system for creating or updating a digital twin comprises an interface, capable of receiving data from a number of conjoint data sources providing data about a physical system, wherein several or all of the conjoint data sources contain data instances that relate to a first entity of the physical system. The system also comprises processing modules, configured for repeatedly extracting and semantically annotating data, by at least one processor, from at least one of the conjoint data sources, wherein semantic annotations of data that have been extracted from a first conjoint data source are influenced by previously extracted and semantically annotated data from at least one other conjoint data source, and at least one export module, configured for exporting the semantically annotated data, by the processor or another processor, into a digital twin system in order to create or update a digital twin based on the semantically annotated data, with the digital twin being a digital representation of the physical system.

"Creating or updating" shall mean creating and/or updating (logical or, inclusive), in other words either creating, updating, or creating and updating. Updating shall mean correcting and/or enriching.

The following advantages and explanations are not necessarily the result of the object of the independent claims. Rather, they may be advantages and explanations that only apply to certain embodiments or variants.

The extracted data from the conjoint data sources are enriched with semantic annotations. This is especially helpful if the conjoint data source themselves do not contain semantic annotations.

The method and system, or at least some of their embodiments, describe a modular and easily expandable solution for creating and/or enriching a digital twin from a plurality of conjoint data sources with heterogenous data. Various embodiments can provide an automated export of heterogenous data types into different existing digital twin systems, for example PlantSight, COMOS or Teamcenter. The original data sources do not need to be changed. Data loss is avoided. The method and system are expandable to include all kinds of data sources with custom types. Import of data from various data sources with various data types can be triggered individually.

The method and system augment the extracting and semantically annotating of the data with knowledge gained from previous annotations. Depending on the type of data imported, already known information can for example be used to dynamically create label spaces and embeddings. This way the processing of new data happens with awareness of already in other data sources identified entities, object and relations. Thus, processing of different data sources does not happen isolated from one another while the system remains modularly expandable to new data sources.

Moreover, expenditures do not end with the initial creation of a digital twin, they continue on into its maintenance. As characteristics of the physical system change, the digital twin needs to be updated accordingly and new data need to be imported to do so. Furthermore, previously not considered data sources might need to be incorporated to enrich an existing digital twin system. Even though there is an abundance of digital twin platforms and systems for storing, viewing and modifying digital twins, these platforms rely on manual data entry. The method and system, or at least some of their embodiments, allow to address the described challenges in an automated fashion.

Although many software solutions relating to digital twin already exist, the process of getting customer data into these systems is often not streamlined. Various embodiments of the method and system fit directly into existing solutions while augmenting these solutions with an automated and reusable setup for importing and maintaining data. They allow to connect isolated digital components maintained on different software or hardware systems into one coherent digital twin. Therefore, at least some embodiments of the method and system reduce cost and efforts in the digital twin creation process and make business more scalable.

Compared to other approaches, the semantic annotations are only an intermediate step in the digital twin creation process. As such, the method and system do not create yet another stand-alone digital representation of the physical system that is not compatible with already existing solutions, but rather augment these solutions with a modular data management pipeline.

In an embodiment of the method and system, each conjoint data source is providing data in its own specific data format. In particular at least one of the conjoint data sources is providing sensor measurements.

For example, the data sources can provide P&ID information, Excel files, system log files, sensor measurements, and 3D models.

In an embodiment of the method and system, the physical system is a building or an industrial facility, in particular an automation system.

In an embodiment of the method and system, the previous semantic annotations are used to create label spaces and/or embeddings that are used for the extracting and semantically annotating of the data.

In an embodiment of the method and system, the semantically annotated data are stored in a knowledge database.

The knowledge base can be used to consolidate the data and represent their current state.

In an embodiment of the method and system, the semantically annotated data are integrated into a graph-based structure. The knowledge database is a graph database storing the graph-based structure.

The graph-based structure serves as a common graph representation into which all of the extracted and semantically annotated data are converted and unified. It integrates all data extracted from the conjoint data sources describing the physical system into a consolidated and coherent representation.

The graph-based structure is dynamic in the sense that the graph can continuously be altered with the creation and elimination of nodes and edges. Furthermore, the graph-based structure of the data is readily queryable, as information retrieval is done efficiently using graph search and content filtering. Changes are also traceable since updates to the graph may be tracked and, thus, any past state recreated. Moreover, the graph is extensible, supporting as many types of nodes, their content, and their relationships as necessary depending on the needs of the use case.

The flexibility and extensibility of the graph-based structure allows modular extension by adding modules for semantically annotating data that are extracted from additional conjoint data sources with new data formats, including semantically poorly described source data, e.g. for buildings, production equipment, and plants.

The semantically annotating of the data provides a mapping from the conjoint data sources to the graph-based structure. The graph-based structure itself can provide transparency in digital twin creation, enrichment and maintenance.

In an embodiment of the method and system, a data model underlying the graph-based structure GBS is expressed using an ontology.

Expressing the data model behind the graph-based structure using an ontology has the advantage that the ontology can be customized to the domain of the digital twin, e.g. an ISA95 ontology for discrete manufacturing systems.

An embodiment of the method and system comprises the additional step of importing, by the processor or another processor, data from at least one digital twin and merging the imported data with the semantically annotated data.

Allowing import of data from any digital twin system leverages potentially already existing information in these models. This is also helpful for the step of exporting the semantically annotated data into the same or another digital twin system: In contrast to existing tools, the existing state of the digital twin and the insights drawn from the import of other data sources can both be leveraged by merging the imported data from the digital twin with the semantically annotated data.

Preferably, the existing digital twin used for import has the same data format as the digital twin that the semantically annotated data will be exported to, for example COMOS.

By taking already available information into account the described system addresses the enrichment of existing digital twins, in addition to also being feasible for the creation of an initial digital twin.

An embodiment of the method and system comprises the additional step of importing, by the processor or another processor, data from at least one digital twin and integrating the imported data into the graph-based structure.

The graph-based structure is advantageously used to integrate data already existing in a digital twin system and thus makes it available for supporting the extracting and semantically annotating of the data from the conjoint data sources.

In all cases where a digital twin is already in place for the physical system, for example in the form of a legacy digital twin, importing its data into the graph-based structure leverages use of the data already available in the digital twin. Also, this step can be advantageously used to initialize the graph-based structure.

As such the graph-based structure provides an interface for exporting integrated data into a digital twin while also leveraging information already existing in the same or other outside systems.

According to an embodiment of the method and system, the step of importing comprises the steps of exporting, by a digital twin system specific extractor, the data from the at least one digital twin into tabular data, mapping, by a mapper, the tabular data to an intermediate graph-based structure, using a digital twin system specific mapping, and integrating, by an integration module, the intermediate graph-based structure into the graph-based structure, using an ontology.

In an embodiment of the method and system, the step of extracting and semantically annotating data is performed by processing modules. Each processing module contains a data source specific extractor that is specific for one of the conjoint data sources.

The processing module has clearly defined interfaces. Therefore, it is possible to design new processing modules for different and even custom data sources and take individual processing needs into account.

If no existing digital twin is available or suitable for importing data, then the pipeline can be started bottom up, by triggering iteratively individual processing modules that import first data. At a later stage, an export module can export data in order to create or update a digital twin.

According to an embodiment of the method and system, the step of extracting and semantically annotating comprises the steps of receiving, by the data source specific extractor, a current state of the graph-based structure, extracting, by the data source specific extractor, data from one of the conjoint data sources and outputting tabular data, and mapping, by a mapper, the tabular data to an intermediate graph-based structure, using a data source specific mapping providing the semantic annotations.

The data source specific extractor processes new data in the conjoint data source with awareness of already integrated data in the graph-based structure GBS.

In order to support the operation of an integration module, each processing module enriches the data that are extracted from the conjoint data source with semantic annotations. The conjoint data sources themselves do not contain semantic annotations. The semantic annotations are provided by the data source specific mapping, which can be manually created beforehand. The mapper then assigns the semantic annotations automatically with the help of the data source specific mapping, thereby producing the intermediate graph-based structure.

An embodiment of the method and system comprises the additional step of integrating, by an integration module, the intermediate graph-based structures into a graph-based structure, using an ontology.

The integration module matches and merges the intermediate graph-based structures into a unified graph.

In an embodiment of the method and system, the step of integrating comprises an entity resolution step, identifying potential duplicate entities in the intermediate graph-based structures, by computing pairwise similarities between entities of the same type, and a merge step, merging the intermediate graph-based structures into the graph-based structure by combining their triples and resolving names of duplicate entities.

The computer-readable storage media have stored thereon instructions executable by one or more processors of a computer system, wherein execution of the instructions causes the computer system to perform the method.

The Computer program is being executed by one or more processors of a computer system and performs the method.

The foregoing and other aspects of the present invention are best understood from the following detailed description when read in connection with the accompanying drawings. For the purpose of illustrating the invention, there are shown in the drawings embodiments that are presently preferred, it being understood, however, that the invention is not limited to the specific instrumentalities disclosed. Included in the drawings are the following Figures:
- Fig. 1: shows an embodiment consisting of several modules, including processing modules PM, an import module IPM, and an integration module ITM,
- Fig. 2: shows one of the processing modules PM depicted in Fig. 1 in more detail,
- Fig. 3: shows an embodiment that has been tailored to the specifics of a production system,
- Fig. 4: shows the import module IPM depicted in Fig. 1 in more detail, and
- Fig. 5: shows the integration module ITM depicted in Fig. 1 in more detail.

In the following description, various aspects of the present invention and embodiments thereof will be described. However, it will be understood by those skilled in the art that embodiments may be practiced with only some or all aspects thereof. For purposes of explanation, specific numbers and configurations are set forth in order to provide a thorough understanding. However, it will also be apparent to those skilled in the art that the embodiments may be practiced without these specific details.

While the Figures show embodiments of the system consisting of modules, the same Figures can also be read as flowcharts for the execution of embodiments of the method. Each module can either be implemented in hardware or as a function or algorithm in software. In other words, the modules can also be seen as execution steps of embodiments of the method.

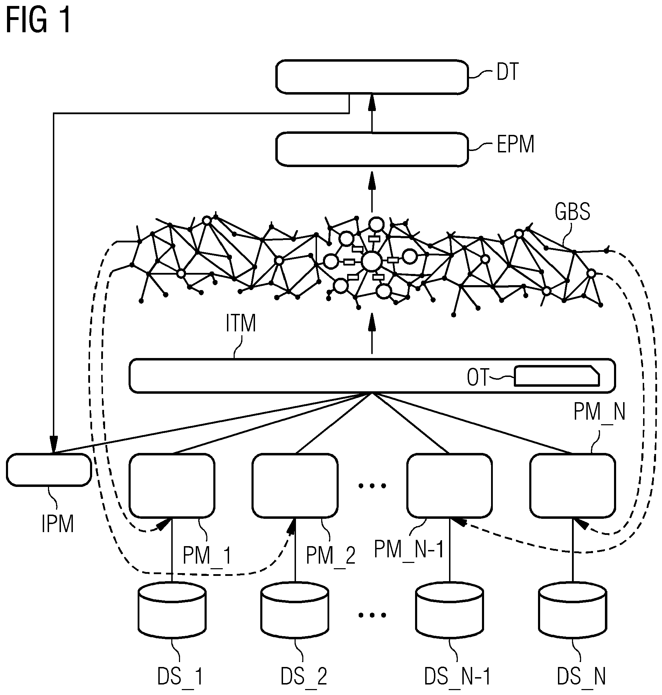

Fig. 1 shows an embodiment consisting of several modules that interact with a graph-based structure GBS (a graph-based representation), feeding information into the graph-based structure GBS and pulling it out from the graph-based structure GBS where needed. The graph-based structure GBS is stored in a graph database (for example BlazeGraph, Neptune, or GraphDB) and modelled using the Resource Description Framework (RDF). A corresponding ontology can be described in any ontology language, for example OWL or RDF Schema.

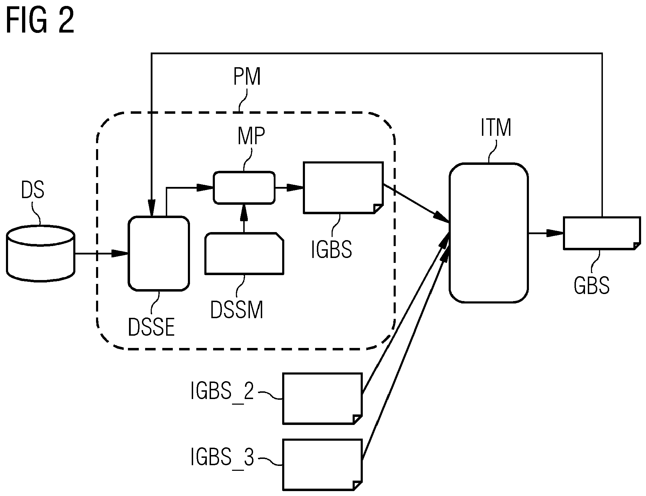

Fig. 1 provides a visual summary of the different modules and their relationships. Fig. 1 also serves as example of how the method can be executed. The functionalities and implementation details of the modules shown in Fig. 1 will be described in the context of Figs. 2, 4, and 5.

The purpose of the embodiment shown in Fig. 1 is to create and/or update one or more digital twins, for example the digital twin DT shown in Fig. 1. The digital twin DT can be stored in and provided by a digital twin system, for example COMOS or PlantSight. As an alternative, several digital twins or digital twin systems can be connected to the system.

The digital twin DT or each of the several digital twins is a digital representation of the same physical system, in particular an industrial facility such as an automation system or a building. The physical system comprises a plurality of assets.

N is a number of processing modules PM that are each processing data stored in a respective data source DS. For example, a first processing model PM_1 is processing PDF files stored in a first data source DS_1. A second processing model PM_2 is processing Excel files stored in a second data source DS_2. A second to last processing module is processing image data stored in a second to last data source DS_N-1. Finally, a last processing module PM_N is processing 3D models stored in a last data source DS_N.

The processing modules PM are extracting data from the data sources DS. The data sources DS are providing conjoint data about the physical system. In other words, at least two of the data sources DS contain data instances that relate to a first entity of the physical system, i.e. to one and the same abstract or physical entity of the physical system. The extracted data also include sensor measurements, for example data extracted from the image data stored in the second to last data source DS_N-1.

An import module IPM is capable of importing data from the digital twin DT.

Likewise, an export module EPM is able to export the current state of the graph-based structure GBS into the digital twin DT. In this way, the digital twin DT can either be created or updated. The implementation of the export module EPM is specific to the target system used for storing and maintaining the digital twin DT.

An integration module ITM integrates the results of the processing modules PM as well as the data imported by the import module IPM into the graph-based structure GBS with the help of an ontology OT. In doing so, the integration module ITM merges not only the data extracted by the processing modules, but also the data imported by the import module IPM into the graph-based structure GBS.

Depending on the prerequisites of the use case, the embodiment shown in Fig. 1 allows for two modes of initialization.

If the digital twin DT is already in place for the physical system, for example in the form of a legacy digital twin, then as a first step, the import module IPM can be triggered. In this way, the graph-based structure is initialized from data already available in the digital twin DT.

If no existing digital twin is available or suitable for importing data, then the pipeline can be started bottom up, by triggering iteratively individual processing modules PM that import first data into the graph-based structure GBS. At a later stage, the export module can export data in order to create or update the digital twin DT.

All of these modules can work in parallel or in any order, and in particular repeatedly.

Fig. 2 shows the processing module PM depicted in Fig. 1 in more detail. The processing module PM depicted in Fig. 2, which is a first instance of a scalable number of individual processing modules that are capable of extracting and processing data from various data sources, e.g. PDF files, images or 3D models. Each processing module outputs an intermediate graph-based structure (a graph-based representation) of the data inputted.

More specifically and with regard to Fig. 2, the processing module PM extracts data from a data source DS with the help of a data source specific extractor DSSE. The data source specific extractor DSSE receives data from the data source DS as well as a current state of the graph-based structure GBS, and outputs data in a tabular form. The data source specific extractor DSSE processes new data in the data source DS with awareness of already integrated data in the graph-based structure GBS. Depending on the data type being extracted, this awareness is realized in different ways:
For example, when processing image data contained in the data source DS, already identified entities and relations in the graph-based structure GBS are used to dynamically construct an object recognition label space. In another example, when processing natural language data, e.g. in PDF files, already identified entities and relations in the graph-based structure GBS are used to construct word and sentence embeddings.

A mapper MP receives a tabular representation of the data from the data source specific extractor DSSE. Using a data source specific mapping DSSM, the mapper MP maps the data to an intermediate graph-based structure IGBS.

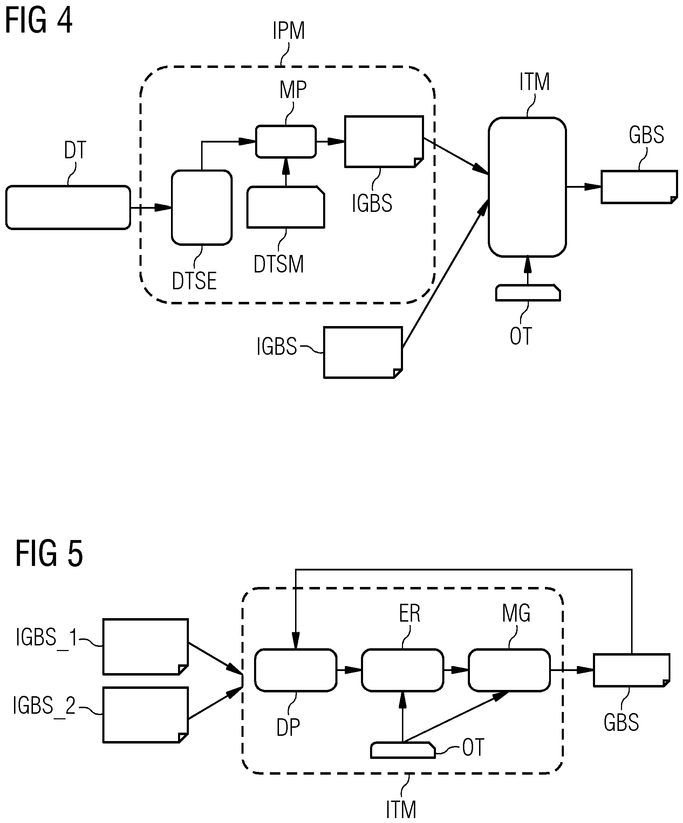

Likewise, further processing modules produce a second intermediate graph-based structure IGBS_2 and a third intermediate graph-based structure IGBS_3. All intermediate graph-based structures are fed into the integration module ITM already known from Fig. 1, which merges and integrates the intermediate graph-based structures into the graph-based structure GBS, as will be described in more detail with regard to Fig. 5.

In order to support the operation of the integration module ITM, the processing module PM enriches the data that are extracted from the data source DS with semantic annotations. The data source DS itself does not contain semantic annotations. The semantic annotations are provided by the data source specific mapping DSSM, which can be manually created beforehand. The mapper MP then assigns the semantic annotations automatically with the help of the data source specific mapping DSSM, thereby producing the intermediate graph-based structure IGBS.

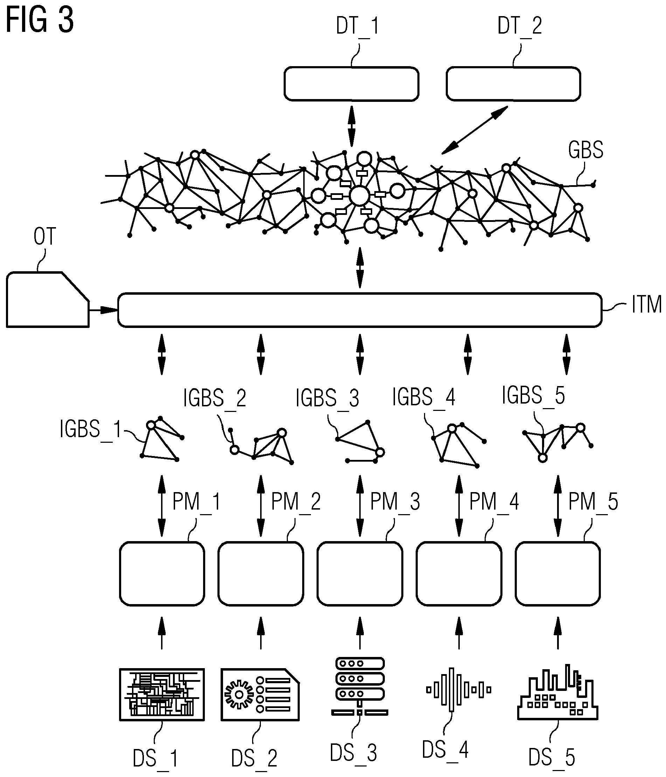

Fig. 3 shows an embodiment of the system that has been tailored to the specifics of a production system. A first digital twin DT_1 is a digital representation of the production system and stored in COMOS. A second digital twin DT 1 is also a digital representation of the production system and stored in PlantSight. Although not depicted in Fig. 3, two export modules allow exporting data from a graph-based structure GBS to each digital twin DT_1, DT_2. Two import modules allow importing data from the digital twins DT_1, DT_2 and feeding them to an integration module ITM, which uses an ontology OT, in particular ISA 88/95.

The integration module receives intermediate graph-based structures IGBS. A first intermediate graph-based structure IGBS_1 is created by a first processing module PM_1, which processes P&ID information stored in a first data source DS_1. A second intermediate graph-based structure IGBS_2 is created by a second processing module PM_2, which processes Excel files containing equipment lists stored in a second data source DS_2. A third intermediate graph-based structure IGBS_3 is created by a third processing module PM_3, which processes system log files stored in a third data source DS_3. A fourth intermediate graph-based structure IGBS_4 is created by a fourth processing module PM_4, which processes sensor measurements provided by a fourth data source DS_4. A fifth intermediate graph-based structure IGBS_5 is created by a fifth processing module PM_5, which processes 3D models stored in a fifth data source DS_5.

The arrows in Fig. 3 describe the information flow in a rather general way. Fig. 1 provides a more detailed and accurate depiction of the information flow.

Fig. 4 shows the import module IPM depicted in Fig. 1 in more detail. The import module IPM makes information from a digital twin DT stored in an existing digital twin system available by exporting it from the digital twin system into a tabular form and mapping it into the graph-based structure GBS. More specifically, a digital twin system specific extractor DTSE receives the data of the digital twin and needs to be implemented specific to the digital twin system used. For example, in case of COMOS the data can be exported using the ExportDB feature provided by COMOS. If multiple digital twin systems with relevant information exist, each one is addressed by an individual import module IPM.
A mapper MP receives the tabular representation of the data from the digital twin system specific extractor DTSE and uses a digital twin system specific mapping DTSM in order to map the tabular representation to an intermediate graph-based structure IGBS. The integration module ITM integrates the intermediate graph-based structure IGBS with the use of an ontology OT into the graph-based structure GBS.

Fig. 5 shows the integration module ITM depicted in Fig. 1 in more detail. The integration module ITM merges two or more intermediate graph-based structures IGBS_1, IGBS_2 into the graph-based structure GBS, which is thus unified. The integration module ITM consists of a data preparation step DP, an entity resolution step ER, and a merge step MG. These steps are applied sequentially to the input structures. During the data preparation step DP, the input data is normalized inter alia by converting all strings to upper or lower case and removing whitespace. For already known data types data cleaning is performed by looking up the input data in the graph-based structure GBS. Next, the entity resolution step ER is performed in order to identify potential duplicate entities in the input data. This is done by computing pairwise similarities between entities of the same type. The similarity computation can be implemented inter alia using a Graph Convolutional Neural Network or hand-crafted distance measures. Moreover, a threshold is used to determine whether two entities are identical. In the merge step MG all graph-representations (the intermediate graph-based structures in their currently processed form) are merged into one representation by combining their triples and resolving the names of duplicate entries found in the previous step. The ontology OT is used in the entity resolution step ER as well as in the merge step MG. The integration module ITM outputs the graph-based structure GBS as one uniform graph-based representation.

The described modules can be implemented in software using suitable algorithms, data models and programming languages, or in hardware.

The method can be executed by a processor such as a microcontroller or a microprocessor, by an Application Specific Integrated Circuit (ASIC), by any kind of computer, including mobile computing devices such as tablet computers, smartphones or laptops, or by one or more servers in a control room or cloud. For example, a processor, controller, or integrated circuit of the computer system and/or another processor may be configured to implement the acts described herein.

The above-described method may be implemented via a computer program product including one or more computer-readable storage media having stored thereon instructions executable by one or more processors of a computing system. Execution of the instructions causes the computing system to perform operations corresponding with the acts of the method described above.

The instructions for implementing processes or methods described herein may be provided on non-transitory computer-readable storage media or memories, such as a cache, buffer, RAM, FLASH, removable media, hard drive, or other computer readable storage media. Computer readable storage media include various types of volatile and non-volatile storage media. The functions, acts, or tasks illustrated in the figures or described herein may be executed in response to one or more sets of instructions stored in or on computer readable storage media. The functions, acts or tasks may be independent of the particular type of instruction set, storage media, processor or processing strategy and may be performed by software, hardware, integrated circuits, firmware, micro code and the like, operating alone or in combination. Likewise, processing strategies may include multiprocessing, multitasking, parallel processing and the like.

The invention has been described in detail with reference to embodiments thereof and examples. Variations and modifications may, however, be effected within the spirit and scope of the invention covered by the claims. The phrase "at least one of A, B and C" as an alternative expression may provide that one or more of A, B and C may be used.

## Claims

1. A method for creating or updating a digital twin,
- with a number (N) of conjoint data sources (DS_1, ..., DS_N) providing data about a physical system, wherein several or all of the conjoint data sources (DS_1, ..., DS_N) contain data instances that relate to a first entity of the physical system,
comprising the steps of
- repeatedly extracting and semantically annotating data, by at least one processor, from at least one of the conjoint data sources (DS_1, ..., DS_N), wherein semantic annotations of data that have been extracted from a first conjoint data source (DS_1, ..., DS_N) are influenced by previously extracted and semantically annotated data from at least one other conjoint data source (DS_1, ..., DS_N), and
- exporting the semantically annotated data, by the processor or another processor, into a digital twin system in order to create or update a digital twin (DT) based on the semantically annotated data, with the digital twin (DT) being a digital representation of the physical system.

2. The method according to claim 1,
- wherein each conjoint data source (DS_1, ..., DS_N) is providing data in its own specific data format, and
- wherein in particular at least one of the conjoint data sources (DS_1, ..., DS_N) is providing sensor measurements.

3. The method according to any of the preceding claims,
- wherein the physical system is a building or an industrial facility, in particular an automation system.

4. The method according to any of the preceding claims,
- wherein the previous semantic annotations are used to create label spaces and/or embeddings that are used for the extracting and semantically annotating of the data.

5. The method according to any of the preceding claims,
- wherein the semantically annotated data are stored in a knowledge database.

6. The method according to claim 5,
- wherein the semantically annotated data are integrated into a graph-based structure (GBS), and
- wherein the knowledge database is a graph database storing the graph-based structure (GBS).

7. The method according to claim 6,
- wherein a data model underlying the graph-based structure (GBS) is expressed using an ontology.

8. The method according to any of the preceding claims,
with the additional step of
- importing, by the processor or another processor, data from at least one digital twin and merging the imported data with the semantically annotated data.

9. The method according to claim 6 or 7,
with the additional step of
- importing, by the processor or another processor, data from at least one digital twin (DT) and integrating the imported data into the graph-based structure (GBS).

10. The method according to claim 9,
wherein the step of importing comprises the steps of
- exporting, by a digital twin system specific extractor (DTSE), the data from the at least one digital twin (DT) into tabular data,
- mapping, by a mapper (MP), the tabular data to an intermediate graph-based structure (IGBS), using a digital twin system specific mapping (DTSM), and
- integrating, by an integration module (ITM), the intermediate graph-based structure (IGBS) into the graph-based structure (GBS), using an ontology (OT).

11. The method according to any of the preceding claims,
- wherein the step of extracting and semantically annotating data is performed by processing modules (PM_1, ..., PM_N), and
- wherein each processing module (PM_1, ..., PM_N) contains a data source specific extractor (DSSE) that is specific for one of the conjoint data sources (DS_1, ..., DS_N).

12. The method according to claim 11,
wherein the step of extracting and semantically annotating comprises the steps of
- receiving, by the data source specific extractor (DSSE), a current state of the graph-based structure (GBS),
- extracting, by the data source specific extractor (DSSE), data from one of the conjoint data sources (DS_1, ..., DS_N) and outputting tabular data, and
- mapping, by a mapper (MP), the tabular data to an intermediate graph-based structure (IGBS_1, ..., IGBS_N), using a data source specific mapping (DSSM) providing the semantic annotations.

13. The method according to claim 12,
with the additional step of
- integrating, by an integration module (ITM), the intermediate graph-based structures (IGBS_1, ..., IGBS_N) into a graph-based structure (GBS), using an ontology (OT).

14. The method according to claim 13,
wherein the step of integrating comprises
- an entity resolution step (ER), identifying potential duplicate entities in the intermediate graph-based structures (IGBS_1, ..., IGBS_N), by computing pairwise similarities between entities of the same type, and
- a merge step (MG), merging the intermediate graph-based structures (IGBS_1, ..., IGBS_N) into the graph-based structure (GBS) by combining their triples and resolving names of duplicate entities.

15. A system for creating or updating a digital twin (DT), comprising:
- an interface, capable of receiving data from a number (N) of conjoint data sources (DS_1, ..., DS_N) providing data about a physical system, wherein several or all of the conjoint data sources (DS_1, ..., DS_N) contain data instances that relate to a first entity of the physical system,
- processing modules (PM_1, ..., PM_N), configured for repeatedly extracting and semantically annotating data, by at least one processor, from at least one of the conjoint data sources (DS_1, ..., DS_N), wherein semantic annotations of data that have been extracted from a first conjoint data source (DS_1, ..., DS_N) are influenced by previously extracted and semantically annotated data from at least one other conjoint data source (DS_1, ..., DS_N), and
- at least one export module (EPM), configured for exporting the semantically annotated data, by the processor or another processor, into a digital twin system in order to create or update a digital twin (DT) based on the semantically annotated data, with the digital twin (DT) being a digital representation of the physical system.

16. Computer-readable storage media having stored thereon:
- instructions executable by one or more processors of a computer system, wherein execution of the instructions causes the computer system to perform the method according to one of the claims 1 to 14.

17. Computer program,
- which is being executed by one or more processors of a computer system and performs the method according to one of the claims 1 to 14.
